Europäisches Patentamt

European Patent Office

Office européen des brevets

(19)

(11) **EP 1 677 422 A1**

## (12) DEMANDE DE BREVET EUROPEEN

(43) Date de publication:
**05.07.2006 Bulletin 2006/27**

(51) Int Cl.:
*H03M 5/00* (2006.01)     *G11B 20/14* (2006.01)

(21) Numéro de dépôt: **05113068.0**

(22) Date de dépôt: **29.12.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **30.12.2004 FR 0453242**

(71) Demandeur: **ALCATEL**
**75008 Paris (FR)**

(72) Inventeur: **Godin, Jean**
**94100 SAINT MAUR DES FOSSES (FR)**

(74) Mandataire: **Sciaux, Edmond**
**Compagnie Financière Alcatel**
**Intellectual Property Group**
**54, rue de la Boétie**
**F-75008 Paris (FR)**

(54) **Dispositif de conversion d'un signal transmis en un signal numérique**

(57)     Dispositif de conversion en un signal numérique d'un signal transmis ($V_{RZ}$) à travers un canal de communication. Le signal transmis correspond à des données numériques encodées sur n états, n étant au moins égal à deux. Le dispositif de conversion comprend des moyens de comparaison asynchrone (21) d'au moins un paramètre du signal transmis à au moins un paramètre seuil ($V_0$), une machine à n états (22) permettant de former au moins un signal à au moins deux états ($V_a$) à partir d'au moins un signal comparé ($V_{cmp}$) en sortie des moyens de comparaison asynchrone, ainsi que des moyens de détection synchrone de changements d'états (23, 24, 25) permettant de générer le signal numérique à partir dudit au moins un signal à au moins deux états et à partir d'un signal d'horloge récupéré ($V_{CLK}$).

Fig. 2

EP 1 677 422 A1

# Description

La présente invention se rapporte au domaine des transmissions numériques. Plus précisément, la présente invention se rapporte au domaine de la conversion en un signal numérique d'un signal transmis à travers un canal de communication, le signal transmis correspondant à des données numériques encodées sur n états.

Lorsque des informations doivent être transmises sur un canal de communication, par exemple un fil électrique, un câble optique, un guide d'onde ou encore des ondes radio, les informations sont converties en un signal de transmission compatible avec des caractéristiques de transmission du canal, comme par exemple la bande passante du canal.

La conversion en signal de transmission comprend classiquement également une étape de codage, dans laquelle les données numériques sont codées sous la forme d'un signal numérique à n états dit signal encodé, n étant au moins égal à deux.

Le signal encodé comprend une suite de symboles synchronisés au rythme d'une horloge, chaque symbole étant codé sur n états et occupant un intervalle de temps correspondant à la période de l'horloge. Dans le cas où n est égal à deux, le symbole est dit bit, et l'intervalle est dit temps bit.

On peut citer par exemple les formats de codage NRZ, pour Non Retour à Zéro, de codage RZ, pour Retour à Zéro, ou encore de codage Manchester.

Le codage NRZ associe directement une grandeur ou paramètre physique, par exemple une tension électrique, à une valeur logique. Dans le cas où n est égal à deux, un bit à 1 est associé à un premier niveau et un bit à zéro est associé à un second niveau. Par convention, le premier niveau correspond classiquement à une tension positive, tandis que le second niveau correspond classiquement à une tension nulle. Le premier niveau peut également correspondre à une tension nulle, et le second niveau à une tension négative.

Le codage RZ, dans le cas où n est égal à deux, associe à une valeur logique à 1 une transition du second niveau vers le premier niveau suivie d'une transition du premier niveau vers le second niveau. Une valeur logique à 0 est associée simplement au second niveau, sans aucune transition. Un signal encodé RZ présentera donc des impulsions d'une largeur égale à une fraction de temps bit, par exemple un demi temps-bit.

Le codage Manchester, également appelé codage biphase, introduit une transition au milieu de chaque intervalle. Dans le cas où n est égal à 2, le codage Manchester peut être réalisé en effectuant un OU exclusif (XOR) entre un signal encodé NRZ correspondant aux données numériques à encoder et un signal d'horloge, ce qui se traduit par un front montant lorsque le bit est à 0, un front descendant dans le cas contraire. Un signal encodé Manchester présentera donc également des impulsions d'une largeur égale à une fraction de temps bit.

La conversion en signal de transmission peut comprendre une étape supplémentaire de modulation d'une onde porteuse électrique par le signal encodé.

Lorsque le canal utilise une porteuse optique, le signal encodé peut par exemple comprendre deux niveaux de puissance optique, et la transmission s'effectuer en bande de base électrique, c'est-à-dire sans modulation d'une sous-porteuse électrique. Un codage NRZ ou un codage RZ sont classiquement utilisés, le premier niveau et le second niveau correspondant classiquement respectivement à une certaine puissance optique et à une puissance optique nulle.

Le signal de transmission est destiné à être transmis sur le canal. A la réception, les données numériques doivent être retrouvées à partir du signal transmis.

Dans le cas d'une transmission optique, le signal optique transmis est converti en un signal électrique par exemple au moyen d'une photodiode.

Un circuit de décision est alors utilisé pour convertir le signal électrique en un signal numérique. Un signal numérique est un signal synchronisé, ne prenant qu'un nombre fini de valeurs.

Le circuit de décision est associé à un circuit de récupération d'horloge, le signal d'horloge récupéré ayant une fréquence correspondant sensiblement à la fréquence d'horloge d'émission. D'une façon générale, le circuit de décision permet de comparer de manière synchrone, à partir du signal d'horloge récupéré, un paramètre physique, tel que sa tension électrique, représentatif des valeurs logiques du signal transmis à au moins une valeur de référence, désignée dans la suite par "paramètre seuil".

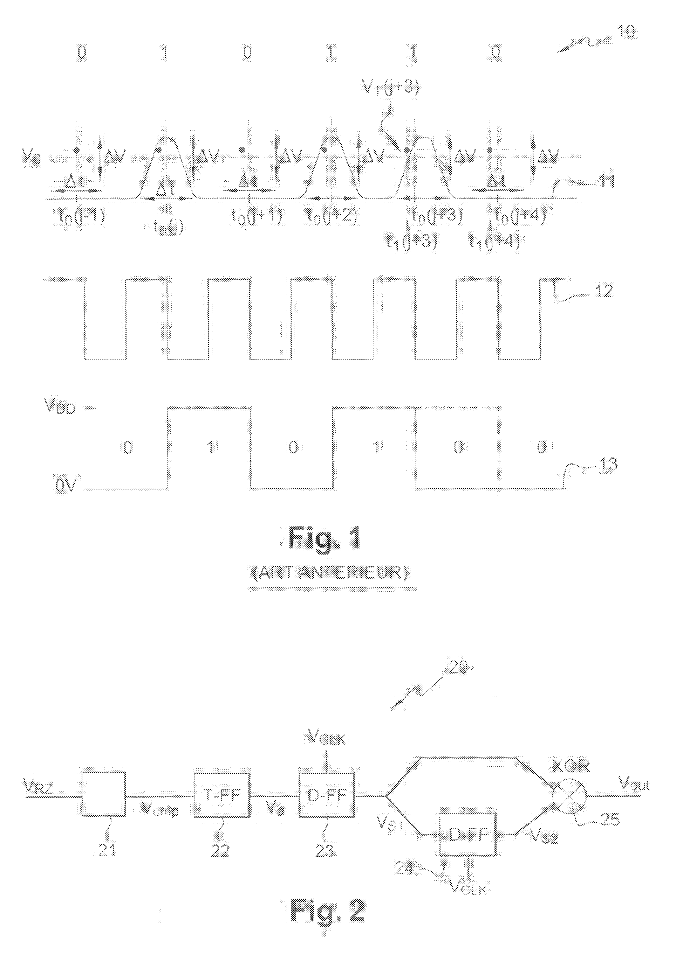

La figure 1 est un exemple de chronogramme illustrant le fonctionnement d'un dispositif de conversion comprenant un circuit de décision, selon l'art antérieur. Les signaux représentés sur la figure 1 sont des signaux de tension électriques et le nombre d'états n est égal à deux.

Le circuit de décision permet de récupérer un signal numérique 13 à partir d'un signal transmis 11 correspondant à des données numériques 10 ici encodées selon le format RZ, puis transmises sur un canal de communication.

A chaque période du signal d'horloge 12, le circuit de décision permet de comparer, sensiblement à un temps prédéterminé $t_0(j)$, la tension du signal transmis 11 à sensiblement une tension seuil prédéterminée $V_0$. Lorsque, au temps prédéterminé $t_0(j)$, la tension du signal transmis 11 est supérieure à sensiblement la tension seuil prédéterminée $V_0$, le circuit de décision évalue la valeur logique du bit à 1, c'est-à-dire dans cet exemple que le signal numérique 13 généré a une amplitude en tension autour d'une tension positive $V_{DD}$. Inversement, si la tension du signal transmis 11 est inférieure à sensiblement la tension seuil prédéterminée, le circuit de décision évalue la valeur logique du bit à 0.

Les valeurs des temps prédéterminés $t_0(j)$ et de la tension de seuil prédéterminée $V_0$ doivent être fixées avec précision, afin d'éviter une estimation erronée.

Toutefois, les conditions pratiques de réalisation ne permettent de fixer les valeurs des temps prédéterminés $t_0(j)$ et de la tension de seuil prédéterminée $V_0$ qu'avec des marges d'erreur en temps $\Delta t$ et en tension $\Delta V$. Or, pour des débits relativement élevés, et en particulier dans le cas d'encodages pour lesquels les signaux transmis correspondants présentent des impulsions occupant seulement une fraction de temps-bit, la marge d'erreur en temps $\Delta t$ peut être relativement élevée comparée à la largeur des impulsions possibles du signal transmis 12, ce qui conduit à une probabilité d'erreur significative.

Le circuit de décision peut en effet, comme représenté sur la figure 1, effectuer une décision pour un couple temps-tension $(t_1(j+3), V_1(j+3))$ à l'intérieur des marges d'erreur en temps $\Delta t$ et en tension $\Delta V$, mais pour lequel la tension du signal transmis 11 est inférieure à la tension choisie $V_1(j+3)$ au temps choisi $t_1(j+3)$ : en conséquence, le circuit de décision évalue à zéro la valeur logique d'un bit correspondant à une donnée numérique à 1.

Plus généralement, dans le cas d'un signal transmis correspondant à des données numériques encodées sur k états, un circuit de décision effectue sa décision, à chaque période du signal d'horloge récupéré, sur la base d'un k-uplet comprenant un temps prédéterminé $t_0(j)$ et k-1 paramètres seuils de détection. Le circuit de décision évalue la valeur logique de chaque symbole en comparant, à chaque temps prédéterminé $t_0(j)$, un paramètre du signal transmis, par exemple la tension ou la phase, aux k-1 paramètres seuils. Les paramètres seuils de détection peuvent typiquement comprendre des tensions seuils $V_0^{(i)}$, i allant de 1 à k-1. De la même façon, les temps prédéterminés $t_0(j)$ et les k-1 paramètres seuils sont fixés pour le circuit de décision avec des marges d'erreurs telles que le circuit de décision risque d'évaluer la valeur logique de certains symboles de manière erronée.

Il est connu, dans le cas d'un encodage RZ, d'utiliser un filtre de Bessel afin d'élargir les impulsions, de telle sorte qu'à des fréquences relativement élevées, la marge en temps $\Delta t$ du circuit de décision soit relativement faible comparée à la largeur des impulsions élargies. Toutefois, du fait de la conservation de l'énergie, les impulsions élargies en sortie du filtre de Bessel ont une amplitude relativement faible, de telle sorte que la marge d'erreur par exemple en tension $\Delta V$ peut être relativement élevée par rapport à l'amplitude des impulsions élargies.

La présente invention vise à améliorer la fiabilité de tels dispositifs de conversion en un signal numérique d'un signal transmis correspondant à des données numériques encodées, en particulier pour des encodages pour lesquels des impulsions peuvent occuper seulement une fraction de temps bit. L'invention peut s'appliquer non seulement aux exemples de formats de modulation mentionné ci-dessus, mais aussi à des format de modulation impliquant des actions simultanées sur plusieurs paramètres physiques du signal transmis.

La présente invention a pour objet un dispositif de conversion en un signal numérique d'un signal transmis à travers un canal de communication, le signal transmis correspondant à des données numériques successives encodées au rythme d'une horloge sur un nombre d'états égal à k, où k est un nombre entier au moins égal à deux et égal à un nombre d'états distinguables attribués à un paramètre physique du signal transmis, le dispositif de conversion comprenant :

- des moyens de comparaison asynchrone de ce paramètre à k-1 paramètres seuil pour fournir au moins un signal comparé,

- une machine à k états permettant de former un signal à k états discrets à partir dudit signal comparé,

- des moyens de détection synchrone de changements d'états synchronisés par un signal d'horloge récupéré pour fournir un signal numérique représentatif des changements d'états dudit signal à k états survenant entre deux périodes d'horloge successives dudit signal d'horloge récupéré.

Chaque sortie de la machine à n états peut par exemple ne changer d'état qu'avec l'apparition de certaines parties caractéristiques d'un signal comparé, comme les fronts montants. Chaque signal à au moins deux états en sortie de la machine à k états peut ainsi présenter des impulsions relativement larges, tout en gardant une amplitude relativement élevée. La conversion du signal transmis en un signal numérique est ainsi plus fiable qu'avec les circuits de décision avec ou sans les filtres de Bessel de l'art antérieur.

La machine à k états peut être asynchrone, de manière à former au moins un signal asynchrone à au moins deux états. La machine à k états peut également être synchronisée, de manière à former au moins un signal synchrone à au moins deux états.

De plus, la présente invention n'est pas limitée par la nature des signaux impliqués. Ainsi, le signal transmis peut être un signal optique, un signal électrique modulé en courant ou encore par exemple un signal électrique modulé en tension ou en phase. Le signal à au moins deux états peut être un signal électrique, ou un signal optique etc.

Les moyens de comparaison asynchrone permettent d'effectuer une comparaison entre un seul paramètre du signal transmis et au moins un paramètre seuil.

Alternativement, plusieurs paramètres du signal transmis peuvent être comparés. Par exemple, des données numériques sur quatre états peuvent être codées de manière binaire sur deux paramètres physiques du signal de transmission, comme par exemple l'amplitude et la phase. Les moyens de comparaison asynchrone peuvent permettre de comparer indépendamment l'amplitude et la phase du signal reçu correspondant à ce signal de transmission, respectivement à une amplitude seuil et à une phase seuil. Une machine à quatre états peut traiter les deux signaux comparés fournis en sortie des moyens de comparaison asynchrone, pour former par exemple deux signaux à deux états, ou bien un signal à quatre états. Grâce au signal d'horloge récupéré, le signal numérique est généré par des moyens de comparaison synchrone de changement d'états, survenant entre deux périodes d'horloge successives, des deux signaux à deux états - ou le cas échéant du signal à quatre états.

Les moyens de comparaison asynchrone permettent avantageusement d'effectuer une comparaison entre l'amplitude du signal transmis et au moins une amplitude seuil : le paramètre comparé du signal transmis est donc dans ce cas représentatif de la différence entre ces amplitudes.

Par exemple, lorsque le signal transmis correspond à des données encodées sur huit états, les moyens de comparaison asynchrone permettent par exemple de comparer l'amplitude du signal transmis à sept amplitudes seuils.

Les moyens de comparaison asynchrone peuvent par exemple comprendre un comparateur, ou tout autre dispositif permettant de comparer le paramètre du signal transmis à au moins un paramètre seuil.

La présente invention n'est cependant pas limitée par la nature du paramètre comparé du signal transmis. Par exemple, le signal transmis peut correspondre à un signal modulé en phase, et les moyens de comparaison asynchrone permettre de comparer la phase du signal transmis à au moins une phase seuil. Dans ce cas, et dans le cas d'un canal de communication optique, les moyens de comparaison asynchrone et la machine à deux états peuvent être intégrées en un seul circuit comprenant par exemple deux photodiodes appairées, les photodiodes appairées générant deux signaux décalés l'un par rapport à l'autre, ainsi qu'un circuit de comparaison des phases, de façon à réaliser une détection duale équilibrée.

De manière générale, la présente invention n'est pas limitée par le nombre de composants mis en oeuvre. Les moyens de comparaison asynchrone, la machine à k états et les moyens de détection synchrone des changements d'états peuvent être regroupés dans un seul composant, par exemple un circuit intégré ou un microcontrôleur.

Le nombre k d'états est avantageusement égal à deux. Le signal transmis correspond alors à des données numériques encodées sur deux états, et la machine à k états comprend alors une machine à deux états. Les moyens de comparaison asynchrone peuvent permettre de comparer l'amplitude du signal transmis à une seule amplitude seuil.

La présente invention n'est bien entendu pas limitée par un nombre d'états égal à deux. Certains encodages, comme par exemple le MLT3, permettent de générer des signaux sur trois états. De plus, des données numériques binaires peuvent classiquement être regroupées sous formes de symboles de $2^k$ états, k étant supérieur à zéro. Le nombre n d'états peut donc être égal à trois, $2^k$, ou tout autre nombre supérieur ou égal à deux.

Plus généralement, les données numériques peuvent être codées sur N grandeurs (ou paramètres) physiques indépendantes (par exemple, pour un signal optique, la puissance, la phase et la polarisation), chacune de ces grandeurs pouvant prendre $k_i$ valeurs distinctes ($k_i$ étant typiquement compris entre 2 et 4). Le nombre d'états distincts transmis est alors n, où :

$$n = \prod_{i=1}^{N} k_i$$

Ainsi, la présente invention a aussi pour objet un dispositif de conversion en un signal numérique d'un signal transmis à travers un canal de communication, le signal transmis correspondant à des données numériques successives encodées au rythme d'une horloge sur n d'états définis par $k_i$ états distinguables attribués respectivement à plusieurs paramètres physiques indépendants du signal transmis, caractérisé en ce qu'il comporte plusieurs dispositifs réalisés comme indiqué ci-dessus, ces dispositifs étant adaptés respectivement aux traitements des paramètres physiques du signal transmis, n étant le produit des nombres $k_i$ d'états distinguables associés respectivement auxdits paramètres physiques.

Le canal de communication comprend avantageusement une fibre optique. Les fibres optiques permettent en effet des débits relativement élevés, par exemple 40 Gbits/s, de telle sorte que la présente invention trouve ici une application particulièrement avantageuse.

En effet, les dispositifs de conversion selon l'art antérieur comprenant un filtre de Bessel comprennent également des composants supplémentaires, par exemple une photodiode. Or, pour des débits relativement élevés, les composants supplémentaires peuvent présenter une fréquence de coupure relativement faible, de telle sorte que ces composants supplémentaires ont une fonction de transfert sensiblement différente de 1 pour des débits relativement élevés. En conséquence, la fonction de transfert du dispositif de conversion selon l'art antérieur n'est pas forcément connue : le circuit de décision risque de choisir un n-uplet avec des marges d'erreurs relativement élevées par rapport à la précision du signal en sortie du filtre de Bessel. Le circuit de décision risque d'évaluer la valeur logique de certains bits de manière erronée. De plus, les caractéristiques du filtre de Bessel lui-même dépendent du débit.

La présente invention, de par l'étape de comparaison asynchrone et le traitement effectué par la machine à deux ou plusieurs états, permet de relativement s'affranchir de la valeur exacte du débit de symboles du signal transmis quant à la fiabilité de la conversion.

La présente invention n'est toutefois pas limitée par la nature du canal de communication, ni par l'ordre de grandeur du débit de symboles utilisé. Le canal de communication peut par exemple comprendre un câble ou bien encore des ondes radio.

L'invention s'applique avantageusement au cas où le signal transmis correspond à des données numériques encodées RZ. En effet, le codage RZ fait intervenir deux transitions par temps bit lorsque le bit associé est à 1, c'est-à-dire que des impulsions du signal transmis ont une largeur relativement faible. Pour un même débit relativement élevé, les circuits de décision selon l'art antérieur offrent en effet une fiabilité moindre pour retrouver des données numériques encodées RZ que des données numériques encodées NRZ.

La machine à k états est alors à deux états et comprend avantageusement une bascule T. Une telle bascule comprend une entrée et une sortie. La valeur de la sortie change d'état par exemple à chaque front montant de l'entrée. Ainsi, pour un signal transmis correspondant à des données numériques encodées RZ, le signal asynchrone sur deux états formé à la sortie de la bascule T garde une même valeur entre deux fronts montants du signal comparé, c'est-à-dire entre deux bits à 1.

Une bascule T est particulièrement bien adaptée pour un encodage RZ, car le signal asynchrone sur deux états comprend des impulsions d'une largeur au moins égale à sensiblement un temps bit, facilitant par là une détection ultérieure des valeurs logiques des bits.

Les moyens de détection synchrone des changements d'états comprennent avantageusement des moyens de synchronisation et des moyens de détection des changements d'états.

Les moyens de synchronisation et les moyens de détection des changements d'états peuvent être à la suite les uns des autres ou bien intercalés.

Les moyens de synchronisation peuvent comprendre par exemple un circuit échantillonneur recevant le signal asynchrone à deux états et déclenché par le signal d'horloge récupéré.

Les moyens de synchronisation comprennent avantageusement une première bascule D permettant de former un premier signal binaire synchronisé, ladite première bascule D recevant en entrée ledit signal à deux états et étant synchronisé par le signal d'horloge récupéré, et les moyens de détection des changements d'états comprennent :

- une seconde bascule D permettant de former un second signal binaire synchronisé, ladite seconde bascule D recevant en entrée ledit premier signal binaire synchronisé et étant synchronisé par le signal d'horloge récupéré, et

- une porte OU exclusif recevant en entrées lesdits premier et second signaux binaires synchronisés et formant en sortie ledit signal numérique.

Une telle implémentation, indiquée à titre d'exemple, permet de fournir en sortie le signal numérique, dans lequel chaque bit à 1 est représenté par un premier niveau, et chaque bit à 0 est représenté par un second niveau pendant la durée du temps bit. Ce signal numérique peut être utilisé sans mise en forme supplémentaire dans un circuit électronique numérique, par exemple un circuit de démultiplexage ou un microprocesseur.

Le dispositif de conversion est avantageusement réalisé en technologie bipolaire. La technologie bipolaire, et en particulier en Silicium Germanium, ou encore en Phosphure d'Indium, permet en effet de réaliser un dispositif de conversion apte à traiter des débits relativement élevés.

La présente invention n'est bien entendu pas limitée par la nature de la technologie utilisée. Le dispositif de conversion peut par exemple être réalisé en technologie BiCMOS, CMOS ou HEMT.

La présente invention a également pour objet un dispositif de réception d'un signal reçu à la sortie d'un canal de communication, le signal reçu étant un signal transmis correspondant à des données numériques encodées sur plusieurs états, comprenant :

- un circuit de décision synchronisé par le signal d'horloge récupéré permettant de comparer de manière synchrone un paramètre du signal transmis à au moins un paramètre seuil et apte à produire un premier signal numérique résultant,

- un dispositif de conversion conforme à la description ci-dessus et apte à produire un second signal numérique en réponse au signal transmis, et

- des moyens de choix pour sélectionner ledit premier signal numérique ou ledit second signal numérique.

Un tel dispositif de réception combine un circuit de décision classique au dispositif de conversion selon la présente invention, de telle sorte que la conversion du signal transmis en signal numérique peut être effectuée par le dispositif le plus adéquat parmi au moins le circuit de décision et le dispositif de conversion. Le choix du dispositif adéquat peut par exemple être effectué en fonction de la nature du codage des données numérique, du débit etc.

Les moyens de choix du dispositif générant effectivement le signal numérique peuvent par exemple comprendre un premier dispositif et un second dispositif. Le premier dispositif transmet la valeur d'un champ du signal reçu au second dispositif, lequel effectue une sélection depuis le dispositif adéquat vers une sortie du dispositif de réception selon la valeur du champ.

Alternativement, les moyens de choix du dispositif générant effectivement le signal numérique peuvent comprendre un cavalier de telle sorte que le choix est effectué manuellement.

Alternativement, les moyens de choix du dispositif adéquat peuvent par exemple comprendre un registre programmable dont la valeur indique quel dispositif doit être utilisé pour générer effectivement le signal numérique.

L'invention est décrite ci-après plus en détail à l'aide de figures ne représentant qu'un mode de réalisation préféré de l'invention.

La figure 1, déjà commentée, est un exemple de chronogramme illustrant le fonctionnement d'un dispositif de conversion comprenant un circuit de décision, selon l'art antérieur.

La figure 2 est un schéma d'un exemple de dispositif de conversion selon un mode de réalisation préféré de la présente invention.

La figure 3 est un exemple de chronogramme illustrant le fonctionnement du dispositif de conversion illustré, selon le mode de réalisation préféré de la présente invention.

La figure 4 est un schéma d'un exemple de dispositif de réception comprenant un dispositif de conversion selon un autre mode de réalisation de la présente invention.

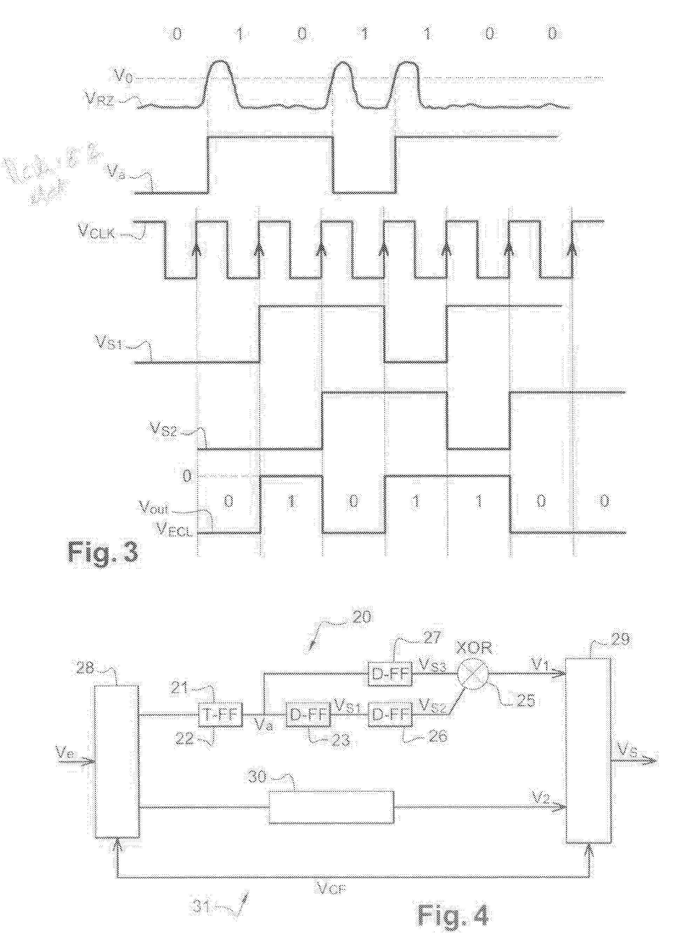

On notera que des éléments ou parties identiques ou similaires ont été désignés par les mêmes signes de référence sur les figures 2, 3 et 4.

L'exemple illustré sur la figure 2 de dispositif de conversion selon le mode de réalisation préféré de la présente invention permet de convertir en un signal numérique un signal transmis en bande de base sur une fibre optique et correspondant à des données numériques encodées RZ sur deux états. Le signal transmis est traité, par exemple via une photodiode non représentée et un amplificateur non représenté, de telle sorte que le signal transmis $V_{RZ}$ est un signal électrique modulé en tension.

Le dispositif de conversion 20 comprend des moyens de comparaison asynchrone 21, par exemple un comparateur, permettant de comparer la tension du signal transmis $V_{RZ}$ à une tension seuil $V_0$. Le signal comparé $V_{cmp}$, non représenté sur la figure 3 mais représentatif de la différence entre les niveaux de tension du signal transmis $V_{RZ}$ et la tension seuil $V_0$, est envoyé à une entrée d'une machine à deux états 22, ici une bascule T.

La bascule T 22 permet de fournir un signal asynchrone $V_a$ à deux états discrets, dont l'état bascule d'un état à l'autre sur les fronts montants du signal comparé $V_{cmp}$. Le signal asynchrone à deux états $V_a$ présent à la sortie de la bascule T 22 change ainsi d'état chaque fois que la tension du signal transmis $V_{RZ}$ augmente en dépassant sensiblement la tension seuil $V_0$.

Le signal asynchrone à deux états $V_a$ ne prend sensiblement que deux valeurs, hormis pendant des temps de transitions, et ce pendant des durées au moins égales à un temps bit, permettant par-là de faciliter la décision quant aux valeurs logiques des bits.

Des moyens de détection synchrone comprennent deux bascules D 23, 24 et une porte logique OU exclusif 25.

Un circuit de récupération d'horloge non représenté permet de récupérer un signal d'horloge $V_{CLK}$ ayant une fréquence correspondant sensiblement au débit du signal transmis $V_{RZ}$.

Une première bascule D 23 recevant en entrée le signal asynchrone à deux états $V_a$ et synchronisés par le signal d'horloge récupéré $V_{CLK}$ permet de former un premier signal binaire synchronisé $V_{S1}$.

Une seconde bascule D 24 recevant en entrée le premier signal binaire synchronisé $V_{S1}$ et synchronisés par le signal d'horloge récupéré $V_{CLK}$ permet de former un second signal binaire synchronisé $V_{s2}$, correspondant au premier signal binaire synchronisé $V_{S1}$ décalé temporellement d'une période du signal d'horloge récupéré $V_{CLK}$.

La porte OU exclusif 25 recevant en entrées les premier et second signaux binaires synchronisés $V_{S1}$ et $V_{S2}$ permet de former le signal numérique $V_{out}$. Ce signal numérique $V_{out}$ est représentatif des changements d'états du signal asynchrone à deux états $V_a$ survenant entre deux périodes d'horloge successives du signal d'horloge récupéré. Il peut être utilisé sans mise en forme supplémentaire dans un circuit électronique numérique, par exemple un démultiplexeur temporel ou un microprocesseur.

Le dispositif de conversion 20 selon le mode de réalisation préféré de la présente invention comprend des éléments, c'est-à-dire la bascule T, les bascules D et la porte OU exclusif, connus en soi et réalisables par l'homme du métier. Pour des débits relativement élevés, de l'ordre de 40 Gbits/s, ces différents éléments peuvent être intégrés sur un seul circuit intégré. Des transistors bipolaires peuvent être utilisés. Dans ce cas, par exemple, chaque bit à 1 du signal numérique $V_{out}$ est représenté par une tension sensiblement nulle, et chaque bit à 0 est représenté sensiblement par une tension négative $-V_{ECL}$, pendant la durée du temps bit.

La description qui précède concerne le cas particulier où, pour coder les données numériques on a utilisé l'amplitude du signal comme unique paramètre physique et attribué seulement deux états à ce paramètre. Pour les cas où un autre paramètre serait utilisé, la transposition consiste simplement à remplacer les moyens de comparaison de tensions 21 par des moyens de comparaison adaptés au paramètre choisi, comme par exemple un comparateur de phase si on utilise la phase comme paramètre.

Si de plus on choisit de coder les données au moyen de plusieurs paramètres physiques (tels que amplitude et phase) avec éventuellement plus de deux états pour au moins un des paramètres, le dispositif de conversion pourra comporter plusieurs circuits en parallèle adaptés respectivement aux comparaisons des paramètres choisis avec éventuellement plusieurs seuils. La bascule T 22 sera remplacée par une machine à plusieurs états (parfois aussi appelée "mémoire multi-valuée").

Des détails à propos de ces dispositifs sont donnés par exemple dans les références suivantes:

- Multiple peak resonant tunneling diode for multi-valued memory, Wei, S.-J.; Lin, H.C., Multiple-Valued Logic, 1991., Proceedings of the Twenty-First International Symposium on, Vol., Iss., 26-29 May 1991, Pages:190-195

- Vertical integration of structured resonant tunneling diodes on InP for multi-valued memory applications, Kao, Y.C.; Seabaugh, A.C.; Yuan, H.T., Indium Phosphide and Related Materials, 1992., Fourth International Conference on, Vol., Iss., 21-24 Apr 1992, Pages:489-492.

De même, le traitement logique nécessaire à l'identification du changement d'état (effectué dans le cas n=2 par les bascules D et la porte Ou-exclusif) peut être calculé et implémenté en suivant les indications données dans les ouvrages de références, comme par exemple : *Computer Science and Multiple-Valued Logic, Theory and Applications,* edited by David C. Rine, North-Holland Publishing Company, 1977 (et en particulier le chapitre 2, "Logic Design and Switching Theory" et le chapitre 4, "Physical Components and Implementation")

La figure 4 est un schéma d'un exemple de dispositif de réception comprenant un dispositif de conversion selon un autre mode de réalisation de la présente invention.

Le dispositif de réception 31 comprend un dispositif de conversion 20 selon l'invention, ainsi qu'un circuit de décision 30 classique. Le dispositif de conversion 20 et le circuit de décision 30 permettent de générer respectivement des signaux numériques V1 et V2.

Le dispositif de conversion 20 et le circuit de décision 30 utilisent des signaux d'horloge récupérés qui ne sont pas représentés sur la figure 4.

Le circuit de décision 30 permet de comparer de manière synchrone l'amplitude du signal transmis à une amplitude seuil.

Un signal reçu $V_e$ à la sortie d'un canal de communication peut par exemple véhiculer un message de signalisation comprenant un champ $V_{CF}$ dédié au signal transmis correspondant à des données numériques encodées. Le champ $V_{CF}$ indique quel type de conversion doit être effectué sur le signal transmis. Par exemple, pour des débits relativement élevés, le circuit de décision 30 connu de l'art antérieur peut être relativement peu fiable pour convertir un signal correspondant à des données numériques encodées RZ, mais permet tout de même une conversion d'un signal correspondant à des données numériques encodées NRZ relativement correcte. Le champ $V_{CF}$ peut donc contenir par exemple une indication quant à la nature du codage effectué, RZ ou NRZ.

Un premier dispositif 28 permet de transmettre le champ $V_{CF}$ directement à un second dispositif 29. Le second dispositif 29 reçoit les signaux numériques V1 et V2, respectivement du dispositif de conversion 20 et du circuit de décision 30. La valeur du champ $V_{CF}$ transmis permet au second dispositif de choisir le dispositif adéquat parmi le circuit de décision 30 et le dispositif de conversion 20. Un signal de sortie Vs est formé à partir du signal numérique pertinent.

Dans le cas de données encodées RZ, le premier signal numérique V1 à la sortie du dispositif de conversion 20 est choisi.

Selon le mode de réalisation représenté sur la figure 4, le circuit de conversion 20 comprend une bascule T intégrant des moyens de comparaison asynchrone 21, par exemple des comparateurs, et une machine à deux états 22. Il est en effet connu de réaliser une bascule T à partir de portes logiques à l'intérieur desquelles les comparateurs peuvent par exemple être intégrés.

De plus, un signal asynchrone à deux états $V_a$ à la sortie de la bascule T est envoyé d'une part sur une première bascule D 23 suivie d'une seconde bascule D 26, et d'autre part sur une troisième bascule D 27. La première bascule D et la seconde bascule D 26 permettent de former un second signal binaire synchronisé $V_{S2}$. La troisième bascule D 27 permet de former un troisième signal binaire synchronisé $V_{S3}$. Le second signal binaire synchronisé $V_{S2}$ est ainsi décalé d'un temps bit par rapport au troisième signal binaire synchronisé $V_{S3}$.

La porte OU exclusif 25 permet de former le premier signal numérique V1 à partir du second signal binaire synchronisé $V_{S2}$ et du troisième signal binaire synchronisé $V_{S3}$.

## Revendications

1. Dispositif de conversion (20) en un signal numérique ($V_{out}$) d'un signal transmis ($V_{RZ}$) à travers un canal de communication, le signal transmis correspondant à des données numériques successives encodées au rythme d'une horloge sur un nombre d'états égal à k, où k est un nombre entier au moins égal à deux et égal à un nombre d'états distinguables attribués à un paramètre physique du signal transmis, le dispositif de conversion comprenant :

   - des moyens de comparaison asynchrone (21) de ce paramètre à k-1 paramètres seuil ($V_0..V_{k-2}$) pour fournir au moins un signal comparé ($V_{cmp}$),
   - une machine à k états (22) permettant de former un signal à k états discrets ($V_a$) à partir dudit signal comparé ($V_{cmp}$),
   - des moyens de détection synchrone de changements d'états (23, 24, 25) synchronisés par un signal d'horloge récupéré ($V_{CLK}$) pour fournir un signal numérique (Vout) représentatif des changements d'états dudit signal à k états survenant entre deux périodes d'horloge successives dudit signal d'horloge récupéré.

2. Dispositif de conversion (20) selon la revendication 1, dans lequel k est égal à deux.

3. Dispositif de conversion (20) selon la revendication 2, dans lequel le signal transmis ($V_{RZ}$) correspond à des données numériques encodées RZ.

4. Dispositif de conversion (20) selon la revendication 3, dans lequel la machine à 2 états (22) comprend une bascule T.

5. Dispositif de conversion (20) selon les revendications 1 à 4, dans lequel les moyens de détection synchrone de changements d'états (23, 24, 25) comprennent :

    des moyens de synchronisation, et
    des moyens de détection des changements d'états.

6. Dispositif de conversion (20) selon la revendication 5, dans lequel les moyens de synchronisation comprennent une première bascule D (23) permettant de former un premier signal binaire synchronisé ($V_{s1}$), ladite première bascule D recevant en entrée ledit signal à deux états ($V_a$) et étant synchronisé par le signal d'horloge récupéré ($V_{CLK}$), et les moyens de détection des changements d'états comprennent :

    - une seconde bascule D (24) permettant de former un second signal binaire synchronisé ($V_{s2}$), ladite seconde bascule D recevant en entrée ledit premier signal binaire synchronisé ($V_{s1}$) et étant synchronisé par le signal d'horloge récupéré ($V_{CLK}$), et
    - une porte OU exclusif (25) recevant en entrées lesdits premier et second signaux binaires synchronisés ($V_{s1}$, $V_{s2}$) et formant en sortie ledit signal numérique (Vout).

7. Dispositif de conversion (20) selon l'une des revendications précédentes, dans lequel les moyens de comparaison asynchrone (21) permettent d'effectuer une comparaison entre l'amplitude du signal transmis et au moins une amplitude seuil.

8. Dispositif de conversion (20) selon l'une des revendications précédentes, le dispositif de conversion étant réalisé en technologie bipolaire.

9. Dispositif de conversion en un signal numérique ($V_{out}$) d'un signal transmis ($V_{RZ}$) à travers un canal de communication, le signal transmis correspondant à des données numériques successives encodées au rythme d'une horloge sur n d'états définis par $k_i$ états distinguables attribués respectivement à plusieurs paramètres physiques indépendants du signal transmis, **caractérisé en ce qu'**il comporte plusieurs dispositifs réalisés selon l'une des revendications précédentes, ces dispositifs étant adaptés respectivement aux traitements des paramètres physiques du signal transmis, n étant le produit des nombres $k_i$ d'états distinguables associés respectivement auxdits paramètres physiques.

10. Dispositif de réception (31) d'un signal reçu à la sortie d'un canal de communication, le signal reçu ($V_e$) étant un signal transmis correspondant à des données numériques encodées sur plusieurs états, comprenant :

    - un circuit de décision (30) synchronisé par le signal d'horloge récupéré ($V_{CLK}$) permettant de comparer de manière synchrone un paramètre du signal transmis à au moins un paramètre seuil et apte à produire un premier signal numérique (V2) résultant,
    - un dispositif de conversion (20) selon l'une des revendications précédentes et apte à produire un second signal numérique (V1) en réponse au signal transmis, et
    - des moyens de choix (28, 29) pour sélectionner ledit premier signal numérique (V2) ou ledit second signal numérique (V1).

**Fig. 1**

(ART ANTERIEUR)

**Fig. 2**

Fig. 3

Fig. 4

**Office européen
des brevets**

**RAPPORT DE RECHERCHE EUROPEENNE**

Numéro de la demande

EP 05 11 3068

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 4 504 960 A (YAMADA ET AL) 12 mars 1985 (1985-03-12) * figures 1,2 * * colonne 2 * * colonne 3, ligne 26 - colonne 4, ligne 9 * ----- | 1-10 | INV. H03M5/00 G11B20/14 |
| X | EP 0 689 315 A (MATRA MHS; MHS) 27 décembre 1995 (1995-12-27) * abrégé * * colonne 1, ligne 15 * * colonne 2, ligne 3 - ligne 8 * * colonne 2, ligne 15 - ligne 19 * * colonne 3, ligne 46 - ligne 49 * * colonne 4, ligne 8 - ligne 15 * * colonne 4, ligne 22 - ligne 30 * * colonne 5, ligne 35 - dernière ligne * ----- | 1-10 | |
| X | JP 07 038535 A (DAIDO SIGNAL CO LTD) 7 février 1995 (1995-02-07) * abrégé * * figures 2,3 * ----- | 1-10 | **DOMAINES TECHNIQUES RECHERCHES (IPC)** H03M G11B |
| X | US 4 580 278 A (YAMAMOTO ET AL) 1 avril 1986 (1986-04-01) * abrégé * * figure 2 * * colonne 1, ligne 60 - colonne 2, ligne 10 * * colonne 5, ligne 20 - ligne 55 * ----- | 1-10 | |

Le présent rapport a été établi pour toutes les revendications

| Lieu de la recherche | Date d'achèvement de la recherche | Examinateur |
|---|---|---|
| La Haye | 8 mai 2006 | Rydyger, K |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

**EP 1 677 422 A1**

**ANNEXE AU RAPPORT DE RECHERCHE EUROPEENNE
RELATIF A LA DEMANDE DE BREVET EUROPEEN NO.**

EP 05 11 3068

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-05-2006

| Document brevet cité au rapport de recherche | | Date de publication | Membre(s) de la famille de brevet(s) | | Date de publication |
|---|---|---|---|---|---|
| US 4504960 | A | 12-03-1985 | CA | 1186766 A1 | 07-05-1985 |
| | | | DE | 3226642 A1 | 03-02-1983 |
| | | | FR | 2509890 A1 | 21-01-1983 |
| | | | GB | 2104349 A | 02-03-1983 |
| | | | JP | 58013046 A | 25-01-1983 |
| | | | KR | 8601257 B1 | 01-09-1986 |
| | | | NL | 8202886 A | 16-02-1983 |
| | | | SU | 1301326 A3 | 30-03-1987 |
| EP 0689315 | A | 27-12-1995 | DE | 69515735 D1 | 27-04-2000 |
| | | | DE | 69515735 T2 | 09-11-2000 |
| | | | FR | 2721780 A1 | 29-12-1995 |
| JP 7038535 | A | 07-02-1995 | AUCUN | | |
| US 4580278 | A | 01-04-1986 | JP | 1676408 C | 26-06-1992 |
| | | | JP | 3039352 B | 13-06-1991 |
| | | | JP | 59077605 A | 04-05-1984 |

EPO FORM P0460

Pour tout renseignement concernant cette annexe : voir Journal Officiel de l'Office européen des brevets, No.12/82